# EUROPEAN PATENT SPECIFICATION

(11) **EP 0 486 149 B1**
(45) Date of publication and mention of the grant of the patent: **18.12.1996**
(21) Application number: 91309036.1
(22) Date of filing: 02.10.1991
(51) Int. Cl.: H01J 37/147, H01J 37/317

(54) **Method and apparatus for reducing tilt angle variations in an ion implanter**
Verfahren und Gerät zur Reduzierung der Neigungswinkelschwankungen in einer Ionenimplantierungsmaschine
Méthode et appareil pour réduire les variations de l'angle d'inclinaison dans un implanteur ionique

(30) Priority: 03.10.1990 US 592363
(43) Date of publication of application: 20.05.1992
(73) Proprietor: EATON CORPORATION, Cleveland, Ohio 44114 (US)
(72) Inventor: Ray, Andrew Marlow, Austin, Texas 78759 (US)
(74) Representative: Musker, David Charles

(56) References cited:
- EP-A- 0 132 522
- EP-A- 0 344 513
- WO-A-86/07189
- WO-A-87/06391

## Description

### Field of the Invention

The present invention concerns an ion implanter for treating workpieces and has a particular application in ion implanting semiconductor wafers.

### Background Art

It is known in the semiconductor fabrication art to use an ion beam to dope semiconductor wafers with ion impurities. By scanning a beam across a wafer surface or moving the wafer through a stationary beam the wafer can be uniformly doped.

The angle at which an ion beam impacts a wafer surface (wafer tilt) is an important parameter in ion implantation of the wafer. Recent trends in semiconductor material processing require a decreased ion impact angle variation across the wafer surface.

In a scanning ion beam system, electrostatic deflection plates produce a raster pattern of ion beam impingement on the wafer surface. One set of plates produces a rapid back and forth scan in one direction and a second set of plates provides beam deflection in an orthogonal direction. Such raster scanning results in impact angle variations of ±4° across a 200 mm wafer for a typical ion beam geometry.

Methods have been proposed to reduce this impact angle variation. One proposal suggests using four sets of deflection plates, two horizontal and two vertical, and is referred to as a double deflection system. The beam is first deflected away from an initial trajectory and then, just before striking the wafer, is deflected again to return to a direction parallel to its original, undeflected trajectory.

Use of a double deflection system with large wafer diameters requires deflection plates that are more widely spaced. This requires high deflection voltages that must be scanned and precisely synchronized with the scanning voltages applied to the first set of deflection plates. Another problem is that as the opening in the scan plates increases, electrostatic fringing fields become more difficult to control and become more susceptible to beam space charge effects.

Another known method of reducing tilt variations is to use a mechanically scanned, spinning disk wafer support. If the spin axis is parallel to the beam, no impact angle variations are present. Spinning disk supports have problems achieving control over impact angle while maintaining the necessary condition for an impact angle variation. One example of a prior art patent having a spinning workpiece support is U.S. patent 4,794,305 to Matsukawa.

Another more recent approach is to electrostatically scan the beam in one axis, and then use a highly indexed bending magnet to produce a parallel ribbon beam. The wafer is then scanned mechanically in a direction orthogonal to the ribbon beam to produce a uniform two dimensional implant. U.S. patents 4,276,477 to Enge, 4,687,936 to McIntyre et al. and 4,922,106 to Berrian et al. (corresponding to WO 87/06391) disclose such systems.

### Disclosure of the Invention

In one aspect the invention, as defined by claim 1, provides an ion beam implant system for controllably treating a workpiece, the system comprising: source means for providing ions to treat the workpiece; support means for orienting the workpiece at a location relative the source means; beam forming means for causing ions emitted by the source means to form an ion beam moving in a first trajectory; deflection means for deflecting ions in said ion beam away from said first trajectory by controlled initial deflection amounts along diverging trajectories; control means having an output coupled to said deflection means to adjust the deflecting of said ion beam and thereby control treatment of the workpiece; and lens means for directing the ions deflected by said deflection means to impact trajectories that intercept said workpiece at a uniform, controlled impact angle; characterized: in that said lens means comprises a plurality of electrodes bounding the ion beam travel path for setting up a non-uniform static electric field to intercept and redeflect the ions moving along said diverging trajectories; and by biasing means for controlling respective voltages on the plurality of electrodes so that a strength of the non-uniform static electric field varies across said ion beam travel path in relation to a degree of divergence of the ions in the ion beam from the first trajectory whereby the redeflected ions are directed to said impact trajectories.

The preamble of claim 1 reflects the state of the art according to U.S. patent 4,611,712 to Mobley (corresponding to WO 86/07189), which discloses an apparatus for scanning an ion beam over the surface of a workpiece while maintaining a substantially constant angle of incidence, the apparatus having a beam deflection system followed by a space charge lens.

In accordance with the ion beam implant system of the invention, the lens means has a plurality of lens electrodes arranged in spaced relation to the ion beam travel path and biased to specified control voltages. The resultant electric field created by the voltages of the lens electrodes bends the ion beam by an amount dependent upon the travel path of the ion beam through the electrostatic lens as well as the mass and energy of the ions. The operation of the lens is analogous to the operation of an optical lens since the amount of deflection the ion beam experiences varies with the angle and position at which the ion beam enters the electric field generated by the lens.

In accordance with a preferred embodiment of the invention, the controlled initial deflection and redirection due to operation of the electrostatic lens is accomplished in one dimension. Two-dimensional scanning of a workpiece is accomplished by relative movement of the scanning structure in relation to the workpiece. This can be accomplished by either movement of the workpiece or movement of the beam deflecting structure. An alternative to this preferred design uses a circular scanning motion wherein the deflecting or scanning electrode as well as the electrostatic lens structure is rotated at a controlled rate as the deflected ion beam impacts a circular array of stationary wafers.

In another aspect the invention provides the electrostatic lens defined by claim 6.

In a further aspect the invention provides the method defined by claim 8 for implanting a workpiece with an ion beam.

### Brief Description of the Drawings

Figure 1 is a schematic of an ion implantation system constructed in accordance with the invention;
Figure 2 is a plan view of an electrostatic lens structure for deflecting an ion beam as it passes to the region of a workpiece;
Figure 3 is an elevation view of the Figure 2 electrostatic lens;
Figure 4 is a plan view of an alternative embodiment of an electrostatic lens structure constructed in accordance with the invention;
Figure 5 is an elevation view of the Figure 4 electrostatic lens;
Figure 6 is a graph of bending angle vs. position for the lens structure of Figure 2;
Figure 7 is a graph of electrode voltage vs. position for the lens structure of Figure 2;
Figure 8 is a graph of bending angle vs. position for the Figure 4 electrostatic lens;
Figure 9 is a graph of electrode voltage vs. position for the Figure 4 electrostatic lens;
Figure 10 is a schematic showing a circular scanning ion beam implanter for implanting a plurality of workpieces; and
Figure 11 is an enlarged view of the Figure 5 depiction showing electric field lines created due to application of control voltages to the electrodes of the electrostatic lens.

### Description of the Preferred Embodiments

Turning now to the drawings, an ion implantation system 10 is illustrated having an ion source 12 for directing an ion beam 14 along a trajectory leading to an ion mass analyzing magnet 16. The magnet 16 bends the beam at approximately a right angle and directs ions having an appropriate mass along a travel path through a resolving aperture 20. The shutter 20 rejects ions having an inappropriate mass from the ion beam.

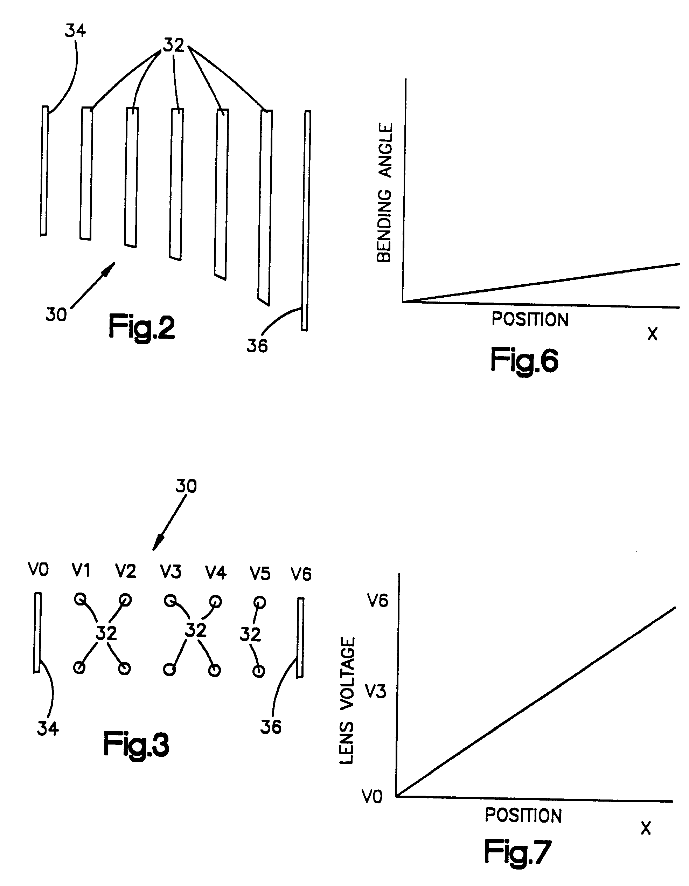

The beam 14 then passes through a pair of deflection electrodes 26, 28. Control voltages applied to the electrodes 26, 28 by a control circuit 29 cause the ion beam to pass through electric fields which deflect the ion beam 14 by a controlled amount. The magnitude of the voltage difference between the two plates 26, 28 controls the amount of deflection. The deflected ion beam enters an electrostatic lens 30 where it is redirected along a travel path generally parallel to the trajectory the beam follows as it exits the analyzing magnet 16. The electrostatic lens 30 includes a number of individual electrodes 32 and a pair of spaced parallel plates 34, 36 (Figure 2). After passing through the lens 30 the ions in the beam are optionally accelerated to a final implantation energy by an electrostatic accelerator 38.

Downstream from the electrostatic lens 30, an ion implantation station 40 includes structure that supports a semiconductor wafer at a position to intercept ions that have been accelerated by accelerator 38. Ion beam collisions with other particles degrade beam integrity so that the entire beam line from the source 12 to the implantation station 40 is evacuated. At the region of the ion implantation station 40 a chamber 42 is evacuated and the wafers are inserted into and withdrawn from load locks to avoid repeated pressurization and depressurization of the chamber 42. A mechanized arm 44 grasps wafers retrieved from a cassette 50 by a shuttle 52 and positions each undoped wafer on a wafer orienter 56. The orienter 56 rotates the undoped wafer to a particular orientation before ion implantation so that as ions strike the wafer they encounter a specific orientation of the crystal lattice structure. The wafer is then moved into a load lock 58 so that a second arm 46 can move the wafers to an implant position within the chamber 42. At the implantation site a wafer support 59 orients the wafer 60 with respect to the ion beam at a specific tilt angle that remains constant due to the parallel ion beam orientation.

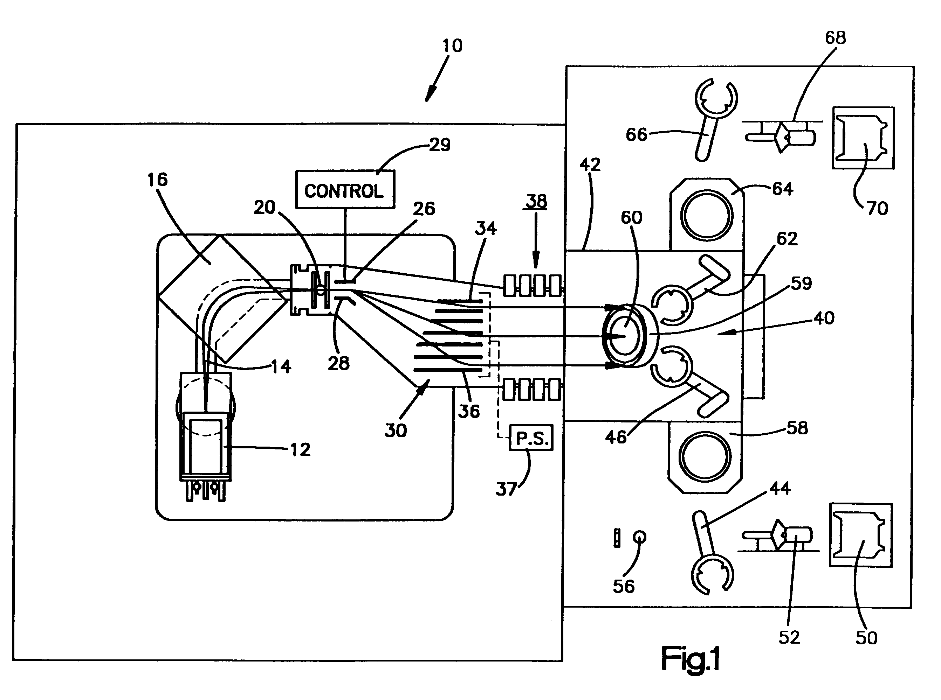

The scanning electrodes 26, 28 produce side-to-side beam scanning of a controlled amount under the direction of the control circuitry 29. The circuitry includes a programmable controller for adjusting the scanning electrode voltages to achieve this wafer scanning. The particular system depicted in Figure 1 produces only side-to-side scanning so that to fully implant a workpiece such as the circular wafers depicted in Figure 1, an additional relative motion between the deflected ion beam and the workpiece is necessary. In this implementation, a linear back and forth scan of a wafer 60 at the ion implantation station 40 is achieved through suitable drive mechanisms (not shown) for the support 59.

Once the wafer 60 has been doped by treatment with the ion beam, the now-doped wafer is removed from the implantation station 40 by a third arm 62. This arm 62 delivers the wafer 60 to a load lock 64 so that a fourth mechanized arm 66 can transfer the wafer to a shuttle 68 that stores the doped wafer in a cassette 70.

Figures 2 and 3 illustrate one of two disclosed lens configurations. Individual ions from the beam 14 are deflected by the voltages of the two metal plates 26, 28 and pass through a region bounded by the two plates 34, 36 and a plurality of metal electrodes 32. The spacing between the two plates 34, 36 define the width of the electrostatic lens 30. As depicted in the graph of Figure 7, the plate 34 is maintained at a constant electric potential less than the potential on the plate 36 by a power supply 37. In Figures 6 and 7 the abscissa "x" designates a distance from the plate 34. The voltages on the electrodes 32 depend upon the relative positioning of those electrodes with respect to the two plates 34, 36. The electrode voltages increase from the plate 34 to the plate 36.

Generally, the voltage on the electrodes is chosen to vary linearly with the position between the two plates 34, 36 and is maintained by a suitably constructed direct current power supply capable of providing a voltage difference between the plates 34, 36 of hundreds of volts.

As seen in Figure 2, the plate 34 is shorter than the plate 36 and the electrode length also varies. The dimensions of the electrodes and plates and the choice of biasing voltages applied to the electrodes and plates produce a bending angle depicted in Figure 6. Those ions that are deflected the greatest amount by the plates 26, 28 are redeflected a greater amount due to longer electrostatic interaction with the electric fields created within the lens.

The position at which ions enter the region between the two plates 34, 36 varies with the initial deflection angle. Due to the compensating effect of the lens 30 a proportional redefection occurs and all ions entering the lens exit along parallel paths. By controlled side to side beam deflection a narrow uniform ion beam that traverses the entire width of the wafer 60 is provided.

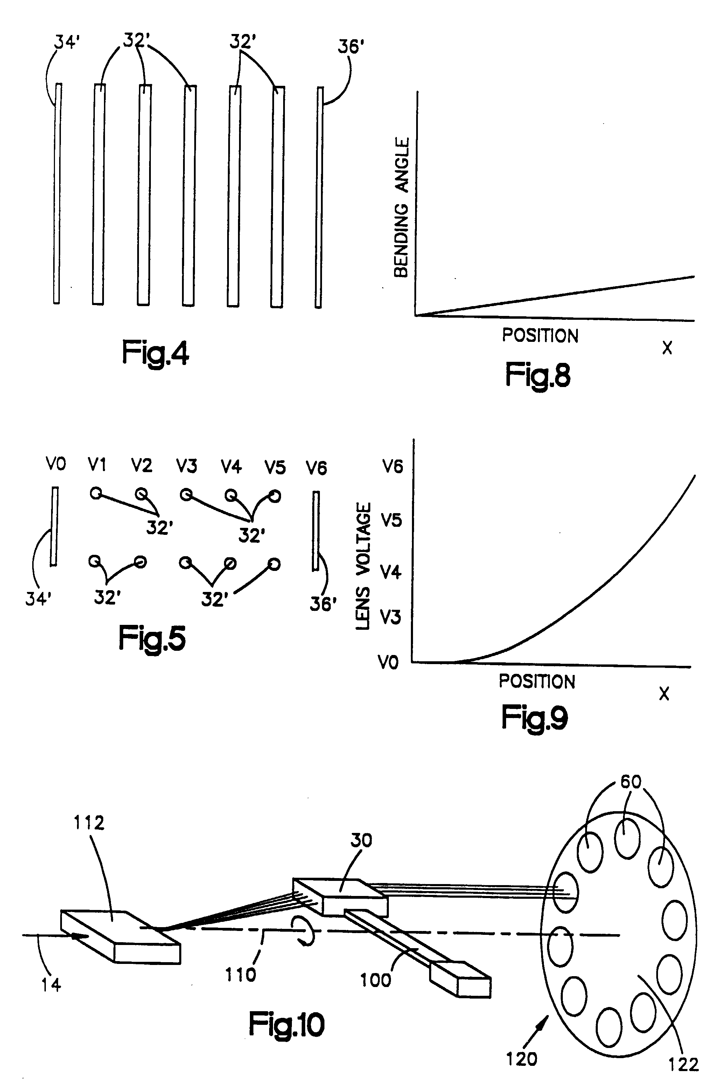

Figures 4 and 5 depict an alternative arrangement for an electrostatic lens 30'. In this arrangement, both plates 34', 36' and all electrodes 32' have the same length. The electrodes and plates are each held at a respective constant voltage but as seen in Figure 9, the voltage variation between the two plates is nonlinear. The net result is a bending angle which is linear with respect to position (see Figure 8).

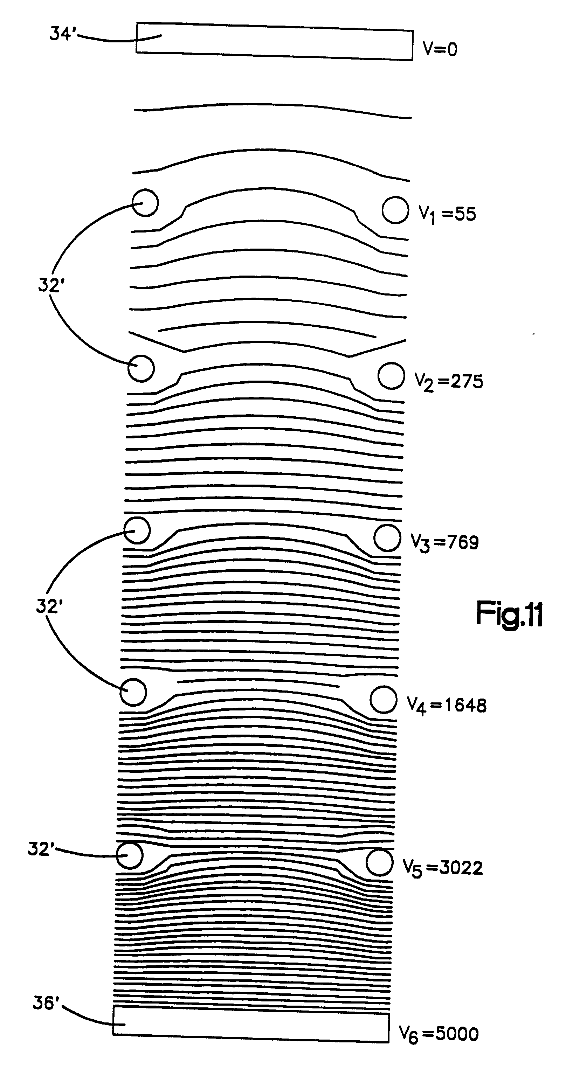

The curve depicted in Figure 9 is of the form Vₐ α X^{m} where m is approximately two and X is the distance from the electrode 34'. Vₐ is proportional to the beam energy and the incoming scan angle as well as the dimensions, number and spacing of the electrodes. In Figure 11 an enlarged view of the Figure 4 depiction is disclosed to show the electric field lines in the vicinity of the electrodes 32' and end plates 34', 36'.

In the Figure 11 depiction the lens has a total width of 240 mm with equal spacing between electrodes. The electrode length is approximately 8 inches. The voltage on each electrode is adjusted for each relevant parameter and then fixed for a particular ion implantation. Although the voltages vary for different parameters the ratio of the voltages should conform to the proportionality given above.

It is possible to adjust the value of the exponent m to tune the ion beam's degree of parallelism and to adjust for fringing field effects at the entrance and exit of the lens. Values of m from 1.8 to 2.2 have been used and the resulting voltages are tabulated below in Table 1.

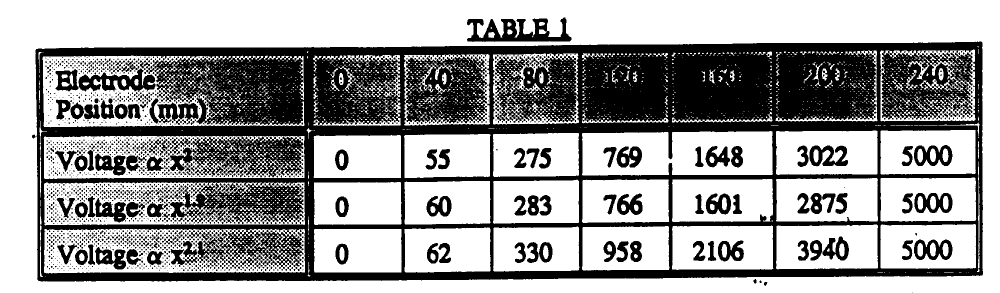

As noted above, in the Figure 1 embodiment of the invention, the wafer is mounted to a support 59 which traverses back and forth through the thin, generally planar ion beam. This avoids the need for a large lens opening with accompanying loss of precise control of the electric field.

Figure 10 depicts an alternative arrangement in which the electrostatic lens 30 is mounted to a elongated support 100 which rotates about an axis 110 corresponding to an initial beam trajectory. Ions within the beam 14 enter a deflection station 112 that includes a pair of parallel deflection plates mounted for rotation. The ion beam is deflected a variable amount and scanned about the rotation axis 110. Rotation of the scanning electrodes and electrostatic lens is simultaneous and preferably accomplished by a mechanical interconnection of the scanning plates and lens. This allows a single motor to rotate both the deflection plates and the lens 30. As the scanning plates deflect the ion beam, the ions pass through the electrostatic lens 30 and are redeflected along parallel paths to an ion implantation station 120. At this ion implantation station a wafer support 122 carries plurality of semiconductor wafers 60.

The wafer support 122 is mounted for movement between a position in which the wafers are placed onto the support and a second position in which the wafers are presented for implantation. The wafers remain stationary as the deflecting plate and electrostatic lens are rotated causing the parallel rays from the ion beam to impact the circularly arranged semiconductor wafers 60.

A slightly different embodiment of the structure depicted in Figure 10 would include fixed deflection plates and electrostatic lens and a rotating wafer support for causing multiple wafers to pass through the parallel rays of the twice deflected ion beam.

The control electronics 29 coupled to the deflection plates 26, 28 is necessary to assure uniform ion implantation. Such electronics is typically coupled to a programmable controller which automatically applies a variable voltage signal across the two parallel plates causing the angle at which the ion beam is deflected to vary with time. By repeating the scanning voltage variation a cyclic beam deflection is provided causing a uniform ion implantation dosage as relative rotation between the ion beam and wafers is provided.

The invention has been described in conjunction with multiple alternate embodiments. It is the intent that the invention include all modifications and alterations from these embodiments falling within the scope of the appended claims.

## Claims

1. An ion beam implant system for controllably treating a workpiece (60), the system comprising:
source means (12) for providing ions to treat the workpiece;
support means (59;122) for orienting the workpiece at a location relative the source means;
beam forming means (16,20) for causing ions emitted by the source means to form an ion beam (14) moving in a first trajectory;
deflection means (26,28; 112) for deflecting ions in said ion beam away from said first trajectory by controlled initial deflection amounts along diverging trajectories;
control means (29) having an output coupled to said deflection means to adjust the deflecting of said ion beam and thereby control treatment of the workpiece; and
lens means (30) for directing the ions deflected by said deflection means to impact trajectories that intercept said workpiece at a uniform, controlled impact angle, said lens means comprising electrode means (32) and biasing means (37) for controlling the voltage on said electrode means;
characterized in that:
said electrode means comprises a plurality of electrodes (32) bounding the ion beam travel path for setting up a non-uniform static electric field to intercept and redeflect the ions moving along said diverging trajectories; and
said biasing means (37) controls respective voltages on the plurality of electrodes so that the strength of the non-uniform static electric field varies across said ion beam travel path in relation to the degree of divergence of the ions in the ion beam from the first trajectory whereby the redeflected ions are directed to said impact trajectories.

2. An ion beam implant system according to claim 1, wherein said deflection means (112) and said lens means (30) are mechanically interconnected and further comprising means to rotate said deflection means and lens means about an axis (110) to sweep over a scanned workpiece.

3. An ion beam implant system according to claim 1, wherein said deflection means (26,28) and said lens means (30) are fixed and the support means (59) moves the workpiece relative the ion beam.

4. An ion beam implant system according to any of claims 1 to 3, wherein said plurality of electrodes (32) are elongate and positioned in spaced relationship to define two rows of electrodes bounding opposite sides of a region through which the ions pass and are redeflected.

5. An ion beam implant system according to claim 4, wherein said lens means (30) includes first and second conductive plates (34,36) spanning a gap between said two rows of electrodes, said biasing means (37) applying voltages to said first and second conductive plates and said plurality of electrodes to set up the non-uniform static electric field.

6. An electrostatic lens for an ion beam implant system, the implant system deflecting the ions in said ion beam away from its first trajectory along diverging trajectories and the lens providing an ion deflection region in which the diverging ions are further deflected to impact trajectories on their way to a target, the lens comprising:
a plurality of elongate conductive electrodes (32) spaced from each other to define a first row of electrodes bounding one side of said region;
a plurality of elongate conductive electrodes (32) spaced from each other to define a second row of electrodes bounding an opposing side of said region;
first and second conductive plates (34,36) spanning a gap between said first and second rows of electrodes and which combine with said first and second rows of electrodes to define the ion deflection region through which ions pass and are deflected before striking the target; and
biasing means (37) for applying respective voltages to the electrodes of the first and second rows and to the first and second conductive plates to produce a static non-uniform electric field within the deflection region, so that the strength of the non-uniform electric field varies across the ion beam travel path in relation to the degree of divergence of the ions in the ion beam from the first trajectory whereby the redeflected ions are directed to said impact trajectories.

7. An electrostatic lens according to claim 6, wherein the biasing means (37) applies voltages to the electrodes (32) and the first and second conductive plates (34,36) to create an electric field tending to cause the ions to exit the deflection region with approximately parallel trajectories.

8. A method for implanting a workpiece with an ion beam, the method comprising:
providing an ion beam having ions that move along a first trajectory; deflecting ions from the first trajectory by controlled amounts to create a diverging ion beam;
creating a non-uniform static electric field at a region for intercepting the diverging ion beam and which redeflects the ions in the diverging ion beam to workpiece impact trajectories that are generally parallel to each other, by controlling respective voltages on a plurality of electrodes bounding said region so that the strength of the non-uniform static electric field varies across said region in relation to the degree of divergence of the ions in the ion beam from the first trajectory; and
providing relative scanning movement between the workpiece and the ion beam subsequent to said region where the ion beam is redeflected.

## Patentansprüche

1. Ein Inonenstrahlimplantationssystem zur steuerbaren Behandlung eines Werkstücks (60), wobei das System folgendes aufweist:
Quellenmittel (12) zum Vorsehen von Ionen zur Behandlung des Werkstücks;
Tragmittel (59; 122) zum Orientieren des Werkstücks an einer Stelle relativ zu den Quellenmitteln;
Strahlformmittel (16; 20) um zu bewirken, daß durch die Quellenmittel emittierte Ionen einen Ionenstrahl (14) bilden, der sich auf einer ersten Flugbahn (Trajektorie) bewegt;
Ablenkmittel (26, 28; 112) zum Ablenken der Ionen in dem erwähnten Ionenstrahl weg von der ersten Flugbahn, und zwar durch gesteuerte anfängliche Ablenkgrößen entlang divergierender Flugbahnen (Trajektorien);
Steuermittel (29) mit einem Ausgang der mit den Ablenkmitteln gekoppelt ist, um die Ablenkung des erwähnten Ionenstrahls einzustellen und dadurch die Behandlung des Werkstücks zu, steuern;
Linsenmittel (30) um die durch die Ablenkmittel abgelenkten Ionen auf Aufschlagflugbahnen zu leiten, die das Werkstück mit einem gleichförmigen gesteuerten Aufschlagwinkel treffen, wobei die Linsenmittel Elelektrodenmittel (32) und Vorspannmittel (37) aufweisen zum Steuern der Spannung an den Elektrodenmitteln;
dadurch gekennzeichnet daß
die Elektrodenmittel eine Vielzahl von Elektroden (32) aufweisen, welche den Ionenstrahllaufpfad begrenzen, um ein nicht gleichförmiges statisches elektrisches Feld vorzusehen zum Auffangen und Rückablenken der sich entlang der divergierenden Flugbahnen bewegenden Ionen; und daß
die Vorspannmittel (37) entsprechende Spannungen an der Vielzahl der Elektroden steuern, so daß die Stärke des nicht gleichförmigen statischen elektrischen Feldes sich über den erwähnten Ionenstrahllaufpfad hinweg verändert, und zwar in Beziehung stehend mit dem Grad oder Ausmaß der Divergenz der Ionen in dem Ionenstrahl von der ersten Flugbahn, wodurch die rückabgelenkten Ionen zu den erwähnten Aufschlagflugbahnen geleitet werden.

2. Ionenstrahlimplantationssystem nach Anspruch 1, wobei die Ablenkmittel (112) und die Linsenmittel (30) mechanisch verbunden sind, und ferner Mittel aufweisen zum Drehen der Ablenkmittel und der Linsenmittel um eine Achse (110), um über ein abgetastetes Werkstück zu schwingen oder zu streichen.

3. Ionenstrahlimplantationssystem nach Anspruch 1, wobei die Ablenkmittel (26, 28) und die Linsenmittel (30) festgelegt sind, und wobei die Tragmittel (59) das Werkstück relativ zum Ionenstrahl bewegen.

4. Ionenimplantationssystem nach einem der Ansprüche 1-3, wobei die erwähnte Vielzahl der Elektroden (32) langgestreckt ist und in beabstandeter Beziehung angeordnet ist, um zwei Reihen von Elektroden zu definieren, die entgegengesetzt liegende Seiten einer Region begrenzen, durch die die Ionen laufen und rückabgelenkt werden.

5. Ionenstrahlimplanmtationssystem nach Anspruch 4, wobei die Linsenmittel (30) erste und zweite Platten (34, 36) aufweisen, die einen Spalt zwischen den zwei Reihen von Elektroden überspannen, wobei die Vorspannmittel (37) Spannungen an die ersten und zweiten Platten anlegen und an die Vielzahl der Elektroden, um das nicht gleichförmige, statische elektrische Feld vorzusehen.

6. Elektrostatische Linse für ein Ionenstrahlimplantationssystem, welches die Ionen in dem Ionenstrahl weg von ihrer ersten Flugbahn (Trajektorie) entlang divergierender Flugbahnen ablenkt, und wobei die Linse eine Ionenablenkregion vorsieht, in der die divergierenden Ionen weiter abgelenkt werden zu Aufschlagflugbahnen auf ihrem Weg zu einem Ziel (Target), wobei die Linse folgendes aufweist:
eine Vielzahl von langgestreckten, leitenden Elektroden (32) beabstandet von einander zur Definition einer ersten Reihe von Elektroden, die eine Seite der erwähnten Region begrenzen;
einen Vielzahl von langgestreckten, leitenden Elektroden (32), die voneinander beabstandet sind, um eine zweite Reihe von Elektroden zu definieren, die eine entgegengesetzte Seite der Region begrenzen;
erste und zweite leitende Platten (34, 36), die einen Spalt zwischen den ersten und zweiten Reihen von Elektroden überspannen und die in Kombination mit den ersten und zweiten Reihen von Elektroden die Ionenablenkregion definieren durch die die Ionen laufen und vor dem Auftreffen auf das Target abgelenkt werden; und
Vorspannmittel (37) zum Anlegen entsprechender Spannungen an die Elektroden der ersten und zweiten Reihen und an die ersten und zweiten leitenden Platten um ein statisches nichtgleichförmiges elektrisches Feld innerhalb der Ablenkregion zu erzeugen, so daß die Stärke des nichtgleichförmigen elektrischen Feldes sich über den Ionenstrahllaufpfad verändert, und zwar in Beziehung mit dem Divergenz- oder Ablenkgrad der Ionen in dem Ionenstrahl von der ersten Flugbahn, wodurch die rückabgelenkten Ionen zu den Aufschlagflugbahnen geleitet werden.

7. Elektrostatische Linse nach Anspruch 6, wobei die Vorspannmittel (37) Spannungen an die Elektroden (32) und die ersten und zweiten leitenden Platten (34, 36) anlegen um ein elektrisches Feld zu erzeugen, welches die Tendenz hat die Ionen zu veranlassen die Ablenkregion mit annähernd parallelen Flugbahnen zu verlassen.

8. Verfahren zum Implantieren eines Werkstücks mit einem Ionenstrahl, wobei das Verfahren folgendes vorsieht:
Vorsehen eines Ionenstrahls der Ionen aufweist die sich entlang einer ersten Flugbahn (Trajektorie) bewegen;
Ablenken der Ionen aus der ersten Flugbahn durch gesteuerte Größen zur Erzeugung eines divergierenden Ionenstrahls;
Schaffen eines nichtgleichförmigen statischen elektrischen Feldes an einer Region zum Auffangen oder Unterbrechen des divergierenden Ionenstrahls, wobei diese die Ionen in dem divergierenden Ionenstrahl rückablenkt zu Werkstück-Auftreffflugbahnen die im allgemeinen paralell zueinander verlaufen, und zwar durch Steuren der entsprechenden Spannungen an einer Vielzahl von Elektroden welche die Region begrenzen, derart, daß die Stärke des nichtgleichförmigen statischen elektrischen Feldes sich über die erwähnte Region hinweg ändert, und zwar in Relation zu dem Grad oder dem Ausmaß der Divergenz der Ionen in dem Inonenstrahl von der ersten Flugbahn; und
Vorsehen einer relativen Abtastbewegung zwischen dem Werkstück und dem Ionenstrahl darauffolgend auf die erwähnte Region oder Zone wo der Ionenstrahl rückabgelenkt wird.

## Revendications

1. Un système d'implantation ionique pour traiter de manière commandée une pièce (60), le système comprenant:
des moyens formant source (12) pour produire des ions destinés à traiter la pièce;
des moyens supports (59; 122) pour orienter la pièce dans un emplacement par rapport aux moyens formant source;
des moyens (16, 20) de formation de faisceau pour provoquer la formation par les ions émis par les moyens formant source d'un faisceau ionique (14) se déplaçant suivant une première trajectoire; des moyens de déviation (26, 28; 112) pour dévier les ions dudit faisceau ionique en éloignement de ladite première trajectoire de quantités de déviation initiales commandées suivant des trajectoires divergentes;
des moyens de commande (29) ayant une sortie connectée auxdits moyens de déviation pour ajuster la déviation dudit faisceau ionique et commander, de ce fait, le traitement de la pièce; et des moyens formant lentille (30) pour diriger les ions déviés par lesdits moyens de déviation suivant des trajectoires d'impact qui interceptent ladite pièce suivant un angle d'impact commandé uniforme, lesdits moyens formant lentille comprenant des moyens formant électrodes (32) et des moyens de polarisation (37) pour commander la tension appliquée auxdits moyens formant électrodes;
caractérisé en ce que:
lesdits moyens formant lentille comprennent une série d'électrodes (32) délimitant le trajet de déplacement du faisceau ionique afin d'établir un champ électrique statique non uniforme pour intercepter et à nouveau dévier les ions se,déplaçant suivant lesdites trajectoires divergentes; et lesdits moyens de polarisation (27) commandent les tensions respectives appliquées aux électrodes de la série d'électrodes de telle sorte que l'intensité du champ électrique statique non uniforme varie en travers dudit trajet de déplacement du faisceau ionique en rapport avec le degré de divergence des ions dans le faisceau ionique par rapport à la première trajectoire de telle sorte que les ions à nouveau déviés sont dirigés suivant lesdites trajectoires d'impact.

2. Un système d'implantation à faisceau ionique selon la revendication 1, dans lequel lesdits moyens de déviation (112) et lesdits moyens formant lentille (30) sont mécaniquement interconnectés et comprenant, en outre, des moyens pour faire tourner lesdits moyens de déviation et lesdits moyens formant lentille autour d'un axe (110) de façon à produire un balayage sur une pièce balayée.

3. Un système d'implantation à faisceau ionique selon la revendication 1, dans lequel lesdits moyens de déviation (26, 28) et lesdits moyens formant lentille (30) sont fixes et les moyens supports (59) déplacent la pièce par rapport au faisceau ionique.

4. Un système d'implantation à faisceau ionique selon l'une quelconque des revendications 1 à 3, dans lequel les électrodes de ladite série d'électrodes (32) sont allongées et positionnées dans une disposition relative espacée pour former deux rangées d'électrodes délimitant les côtés opposés d'une région à travers laquelle les ions passent et sont à nouveau déviés.

5. Un système d'implantation à faisceau ionique selon la revendication 4, dans lequel lesdits moyens formant lentille (30) comportent des première et seconde plaques conductrices (34, 36) s'étendant sur l'intervalle entre les deux rangées d'électrodes, lesdits moyens de polarisation (37) appliquant des tensions auxdites première et seconde plaques conductrices et aux électrodes de ladite série d'électrodes pour produire le champ électrique statique non uniforme.

6. Une lentille électrostatique pour un système d'implantation ionique, le système d'implantation déviant les ions dudit faisceau ionique en éloignement de leur première trajectoire suivant des trajectoires divergentes et ladite lentille fournissant une région de déviation des ions dans laquelle les ions divergents sont à nouveau déviés suivant des trajectoires d'impact sur leur trajet en direction d'une cible, la lentille comprenant:
une série d'électrodes conductrices allongées (32) espacées les unes des autres de façon à former une première rangée d'électrodes délimitant un côté de ladite région;
une série d'électrodes conductrices allongées (32) espacées les unes des autres de façon à former une seconde rangée d'électrodes délimitant un côté opposé de ladite région;
des première et seconde plaques conductrices (34, 36) s'étendant sur l'intervalle entre lesdites première et seconde rangées d'électrodes et qui agissant en combinaison avec lesdites première et seconde rangées d'électrodes pour délimiter la région de déviation des ions à travers laquelle les ions passent et sont déviés avant de frapper la cible; et
des moyens de polarisation (37) pour appliquer des tensions respectives aux électrodes et aux première et seconde plaques conductrices afin de produire un champ électrique statique non uniforme de telle sorte que l'intensité du champ électrique non uniforme varie en travers du trajet de déplacement du faisceau ionique en rapport avec le degré de divergence des ions du faisceau ionique par rapport à la première trajectoire de sorte que les ions à nouveau déviés sont dirigés suivant les dite trajectoire d'impact.

7. Une lentille électrostatique selon la revendication 6, dans laquelle les moyens de polarisation (37) appliquent des tensions aux électrodes (32) et aux première et seconde plaques conductrices (34, 36) de façon à créer un champ électrique qui tend à provoquer la sortie des ions de la région de déviation avec des trajectoires approximativement parallèles.

8. Un procédé pour effectuer l'implantation d'une pièce au moyen d'un faisceau ionique, le procédé comprenant les étapes qui consistent: à produire un faisceau ionique ayant des ions qui se déplacent suivant une première trajectoire;
à dévier les ions de la première trajectoire de quantités commandées pour créer un faisceau ionique divergent;
à créer un champ électrique statique non uniforme dans une région pour intercepter le faisceau ionique divergent, lequel champ dévie à nouveau les ions du faisceau ionique divergent suivant des trajectoires d'impact sur la pièce qui sont approximativement parallèles entre elles, en commandant les tensions respectives qui sont appliquées à une série d'électrodes délimitant ladite région de sorte que l'intensité du champ électrique statique non uniforme varie en travers de ladite région en rapport avec le degré de divergence des ions du faisceau ionique par rapport à la première trajectoire; et à produire un mouvement de balayage entre la pièce et le faisceau ionique en aval de ladite région dans laquelle le faisceau ionique est à nouveau dévié.
